# EUROPEAN PATENT SPECIFICATION

(11) **EP 2 579 457 B1**
(45) Date of publication and mention of the grant of the patent: **12.11.2014**
(21) Application number: 12008281.3
(22) Date of filing: 06.09.2011
(51) Int. Cl.: H03F 1/02

(54) **Power amplifier for mobile telecommunications**
Leistungsverstärker für mobile Telekommunikation
Amplificateur de puissance pour télécommunications mobiles

(43) Date of publication of application: 10.04.2013
(62) Divisional of application: 11290396.8
(73) Proprietor: ALCATEL LUCENT, 92100 Boulogne-Billancourt (FR)
(72) Inventor: Grebennikov, Andrei, Dublin, 15 (IE); Bulja, Senad, Dublin, 15 (IE)
(74) Representative: Sarup, David Alexander

(56) References cited:
- EP-A2- 0 630 104
- JONGSIK LIM ET AL: "A balanced power amplifier utilizing the reflected input power", RADIO-FREQUENCY INTEGRATION TECHNOLOGY, 2009. RFIT 2009. IEEE INTERNATIONAL SYMPOSIUM ON, IEEE, PISCATAWAY, NJ, USA, 9 January 2009 (2009-01-09), pages 88-91, XP031640437, ISBN: 978-1-4244-5031-2

## Description

### Field of the Invention

The present invention relates to a power amplifier employed in mobile telecommunications systems, particularly an RF power amplifier commonly known as a Doherty amplifier.

### Background Art

In mobile telecommunication systems it is required that a power amplifier in a mobile base station should operate with high efficiency and high linearity simultaneously. "Efficiency" is generally regarded as the ratio of RF transmission output power to DC input power. "Linearity" has various measures, but a common measure is ACLR - adjacent channel power leakage ratio. There is a trade off between efficiency and linearity, with improvement in one coming at the expense of another. Many wireless communications systems, such as GSM/EDGE, CDMA2000, or WCDMA/LTE, require that the power amplifier should deliver a wide range of output powers. As a result, being designed for the highest power level with maximum available efficiency, power amplifiers in base stations tend to operate less efficiently at lower power levels consuming a lot of extra dc power. Therefore, there is a challenge to design a base station power amplifier having high efficiency and high linearity not only at maximum output power but also at lower power levels typically ranging from -6 dB and less. It is possible to employ linearization schemes to improve linearity, but these introduce extra complexity.

US Patent No. 2,210,028 to Doherty describes the principle of operation of the Doherty amplifier. A Doherty amplifier includes a main or carrier amplifier, usually biased into class B or AB, with a peaking amplifier coupled in parallel and biased into class C, so as to switch on at modulation peaks. This provides a more efficient use of amplifier capability, since the carrier amplifier may be set to provide maximum power efficiency at saturation, backed off by -6 dB from the peak output. When the peaking amplifier switches in at the -6 dB point to increase power to the antenna load, an impedance inverter at the output of the carrier amplifier senses an increase in load impedance and provides an apparent lower impedance at the carrier amplifier output, thereby increasing power output of the carrier amplifier.

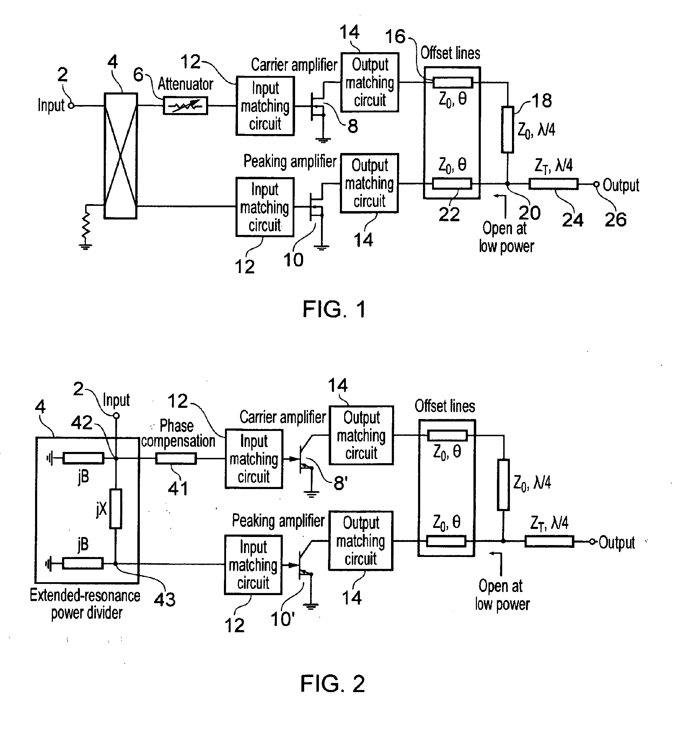

There has been a great deal of development in improving the operation and efficiency of the Doherty Amplifier. One means of improving the efficiency over the whole backoff power range is based on using uneven input power dividers, so that the input signal applied to the carrier amplifier is of a different magnitude to that applied to the peaking amplifier. An uneven input drive is desirable to provide higher drive to the carrier amplifier at a low power region when peaking amplifier is turned off and higher drive to the peaking amplifier when both carrier and peaking amplifiers are turned on, thus increasing efficiency around both peak efficiency points. In J. Kim et al., "Optimum Operation of Asymmetrical-Cells-Based Linear Doherty Power Amplifiers - Uneven Power Drive and Power Matching," IEEE Trans. Microwave Theory Techn., vol. MTT-53, pp. 1802-1809, May 2005, a Doherty amplifier, shown schematically in Figure 1, is described where higher input power is delivered to the peaking amplifier rather than the carrier amplifier for optimised linear power operation, especially for appropriate load modulation. In Figure 1, a Doherty amplifier has an input 2 coupled by an uneven power divider 4, which is adjusted by a variable attenuator 6. Divider 4 is coupled to a carrier amplifier 8 and to a peaking amplifier 10, which comprise FETs, and which have input and output impedance matching circuits 12, 14. The output of carrier amplifier 8 is coupled via a phase offset line length 16 and a quarter wavelength impedance inverting line 18 to an output node 20. The output of peaking amplifier 10 is coupled via a phase offset line length 22 to output node 20. Output node 20 is coupled, via an impedance transforming quarter wavelength line 24, to the output 26 of the Doherty amplifier. Problems with this proposal include resistive losses of the attenuator and that a preliminary optimization of power division ratio is fixed in a final circuit.

M. Nick and A. Mortazawi, "Adaptive Input-Power Distribution in Doherty Power Amplifiers for Linearity and Efficiency Enhancement," IEEE Trans. Microwave Theory Techn., vol. MTT-58, pp. 2764-2771, Nov. 2010 discloses a Doherty amplifier as shown in Figure 2, where similar parts to those of Figure 1 are denoted by the same reference numerals. In Figure 2, the input power divider 4 comprises a so-called extended resonance divider, and a phase compensation line 41, which is coupled to the input of a carrier amplifier 8', which comprises a bipolar transistor. Divider 4 is also coupled to the input of a peaking amplifier 10'. Divider 4 comprises a susceptance jB connected between earth and a divider output 42 coupled to amplifier 8'. A further susceptance jB is connected between earth and a divider output 43, which is coupled to peaking amplifier 10'. A reactance jX is connected between outputs 42, 43. The power division ratio between amplifiers 8', 10' is dependent on the amount of input power, being dependent on the ratio of (varying) input admittances of amplifiers 8', 10'. The behaviour mainly depends on the reflected power from the peaking amplifier. The input impedance of the peaking amplifier exhibits non-linear behaviour and is a strong function of the bias voltage. The major problems therefore with this approach are the dependence of the input power divider division ratio on the input impedance of the transistor devices which is different for different devices, and further a lack of adjustment possibilities.

### Summary of the Invention

The present invention provides an RF power amplifier including a carrier amplifier, and at least one peaking amplifier,
a power dividing means coupled between an input of the power amplifier and inputs of said carrier amplifier and said one peaking amplifier, the output of said carrier amplifier being coupled through an impedance inversion means to a power amplifier output, and the output of said one peaking amplifier being coupled to said carrier amplifier output, and wherein said one peaking amplifier is configured to switch on with increase in input power,
said power dividing means including includes a coupler having four ports including an input port, wherein said carrier amplifier is coupled to one of said ports serving as a first outlet port, and said one peaking amplifier is coupled to another of said ports serving as a second outlet port, and including impedance means coupled to said second outlet port, so that, power is partly passed to said one peaking amplifier coupled to the second outlet port, and is partly reflected back into the second outlet port, reappearing at said first outlet port, to which is coupled the carrier amplifier.

Embodiments of the invention provide a highly efficient operation of the base station power amplifier at maximum and backoff output power levels with better linearity performance.

### Brief Description of the Drawings

Preferred embodiments of the invention will now be described, by way of example only, with reference to the accompanying drawings, wherein:
Figure 1 is a circuit diagram of a Doherty amplifier incorporating a power divider, according to Kim referenced above;
Figure 2 is a circuit diagram of a Doherty amplifier incorporating a power divider, according to Nick referenced above;
Figure 3 is a circuit diagram of a Doherty amplifier incorporating a power divider, according to a first embodiment of the invention;
Figure 4 is a circuit schematic of a known branch line coupler, indicating relative phase shifts at ports;
Figures 5(a) and 5(b) are schematic diagrams of two possible limiting states of operation of the amplifier of Figure 3, included for explanation; and
Figures 6 to 8 are circuit diagrams of a Doherty amplifier incorporating a power divider, according to second, third and fourth embodiments of the invention, with different means of creating a signal envelope; and
Figure 9 is a circuit diagram of a Doherty amplifier incorporating a power divider, according to a fifth embodiment of the invention, being a multi-stage Doherty amplifier.

### Description of the Embodiments

In the embodiments to be described, the input divider, which comprises two directional couplers and two varactor diodes biased with the same voltage, is based on reflection-type principle where one part of the input signal is reflected from,the capacitors and flows to the isolation port of the first coupler and the other part flows through to the output port of the second coupler. For zero capacitances there is no reflection and power flows only to the peaking amplifier, but for infinite capacitances providing zero reactances all power is reflected and flows to the carrier amplifier. As a result, by optimizing the values of the capacitances by proper varactor biasing, an optimum input power division for higher efficiency and better linearity can be achieved. The control voltage to the varactors is supplied from the feedback path and digital signal processing unit.

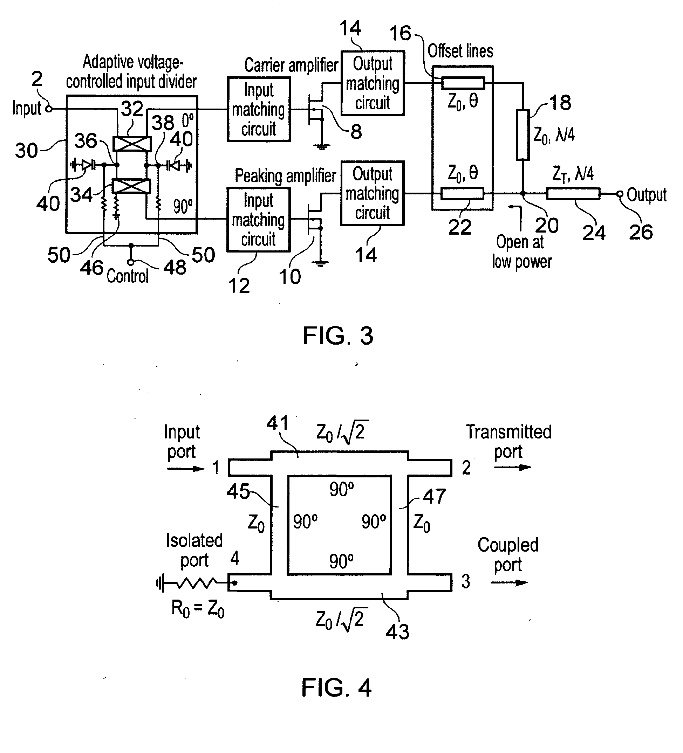

In the Figures, similar parts are denoted by the same reference numeral. Referring to Figure 3, a Doherty amplifier includes an uneven power divider 30, comprising first and second four port couplers 32, 34 coupled together by lines 36, 38, to each of which is connected a voltage controlled capacitor (varactor) 40, the other terminals of the varactors being coupled to earth.

A schematic view of a branch line coupler is shown in Figure 4, with Input port 1 connected by a conductive path (e.g. microstrip) 41, which comprises a quarter wavelength transmission line (with characteristic impedance Z₀/√2), to Transmitted port 2. Isolated port 4 is connected by a conductive path 43, a quarter wavelength transmission line (characteristic impedance Z₀/√2), to Coupled port 3. Port 1 is connected to port 4 by a quarter wavelength conductive path 45 (characteristic impedance Z₀), and transmitted port 2 is connected to coupled port 3 by a quarter wavelength conductive path 47 (characteristic impedance Z₀). The theory of operation of such couplers is well understood, and relative phase shifts of 90° occur between adjacent ports as shown. In particular there is a relative phase shift of 90° between Transmitted port 2 and Coupled port 3. In the usual configuration as shown of the coupler, there is zero output at port 4, and this is connected to ground via a terminating impedance. However in this embodiment, the designation of the ports is not significant, but arbitrary, since the coupler exhibits reciprocity and in the arrangement shown in Figure 3 input signals may flow into a coupler via various ports.

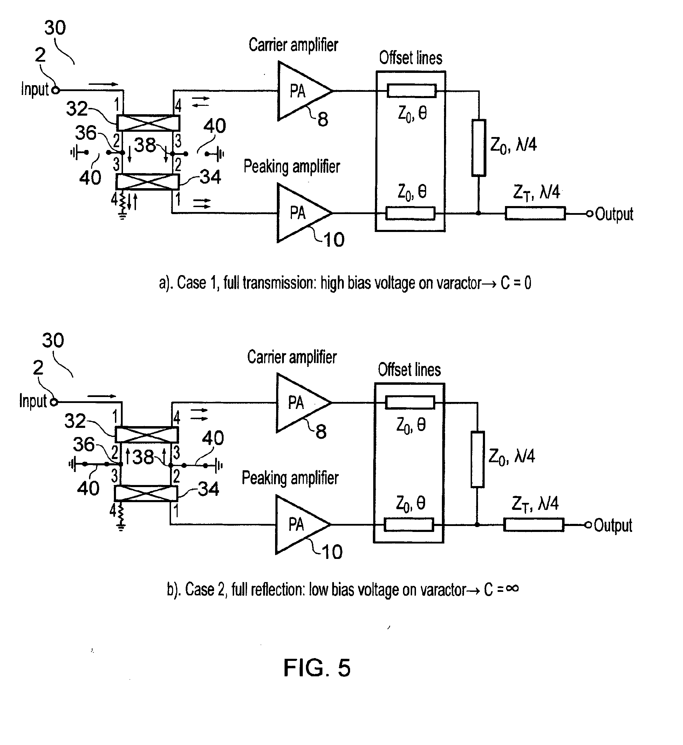

It may be seen from Figures 3, 4 and 5, that port 2 of coupler 32 is directly connected by line 36 to port 3 of coupler 34, and that port 3 of coupler 32 is directly connected by line 38 to port 2 of coupler 34. From Figures 3 and 5 it may be seen that the input of amplifier 8 is coupled to port 4 of coupler 32, and the input of amplifier 10 is coupled to port 1 of coupler 34. In addition isolating port 4 of coupler 34 is coupled to earth via a matching impedance 46.

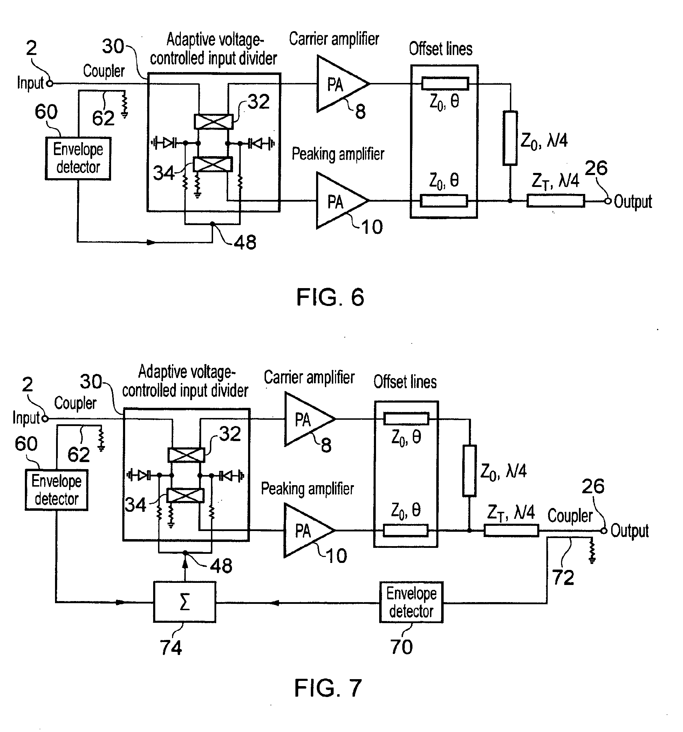

A control signal, representing the envelope of the input signal at 2, is applied to a control input 48, and conducted by lines 50 to the anodes of varactors 40. This signal represents the magnitude of the amplitude of the input signal, smoothed to take out the phase variations due to the base frequency of the input signal. A simple envelope detector may be formed by a diode and integrating capacitor (see: http://en.wikipedia.org/wiki/Envelope detector). Specific forms of envelope detection are described below with reference to Figures 6 to 8.

The manner of operation of divider 30 is explained with reference to Figure 5. A Doherty amplifier at low power input signals will function with only the carrier amplifier 8 operative. But for higher power inputs, 6dB below the maximum value, the peak amplifier becomes operative. These two states are illustrated in Figure 5, Figure 5(a) illustrating the limiting case of the high power state, and Figure 5(b) illustrating the limiting case for the low power state. In practice, the state of the amplifier will be part-way between these two limiting states.

In Figure 5(b), for very low power input signals, the magnitude of the envelope is very small, and hence the control signal will not change the capacitance of varactors 40, from a high value. In the limiting case, the capacitance tends to infinity, and the resultant impedance, 1/jωC, goes to zero. Hence the varactors may be represented by a short circuit to earth, as shown. In this case, the input power conducted through directional coupler 32 will be reflected back at the short circuit discontinuities, and will be wholly transmitted to the carrier amplifier 8. Thus, the input signal at port 1 of coupler 32 is transmitted to ports 2 and 3, and then totally reflected at varactors 40 (with 180° phase shift) back to respective ports 2 and 3. Input power to port 3 will be transmitted to port 4 and thence to carrier amplifier 8. Input power to port 2 will also be transmitted to port 4 and thence to carrier amplifier 8.. As the signal components flow through coupler 32, they will experience 90° phase shifts in the legs 41 - 47, but these shifts add constructively, and all the signal components are transmitted in-phase to amplifier 8.

In Figure 5(a), for high power input signals, the magnitude of the envelope is very large, and hence the control signal will change the capacitance of varactors 40, to a low value. In the limiting case, the capacitance tends to zero, and the resultant impedance, 1/jωC, goes to infinity. Hence the varactors 40 may be represented by an open circuit, as shown. In this case, the input power conducted through coupler 32 will be unaffected by these open circuits, and is conducted into coupler 34, whence into peaking amplifier 10. There are two components for the input signal into peaking amplifier 10, firstly ports 1 and 2 of coupler 32 and ports 3 and 1 of coupler 34. The second component flows through ports 1 and 3 of coupler 32 and ports 2 and 1 of coupler 34. As the signal components flow through couplers 32 and 34, they will experience 90° phase shifts in the legs 41 - 47, but these shifts add constructively, and these two components arrive in phase at the input to peaking amplifier 10. As regards the input signal to carrier amplifier 8, there is no net signal in this limiting case.

Referring to the second embodiment shown in Figure 6, a specific envelope detector 60 is shown, having a current sensing coupling 62 to input 2. As stated above, the envelope detector may comprise an arrangement of rectifying diode and integrating capacitor.

Referring to the third embodiment shown in Figure 7, a further arrangement of envelope detection is shown which gives a more accurate estimate of the envelope of the power signal. A further envelope detector 70 is provided, coupled at 72 to sense the signal at the output 26 of the Doherty amplifier. The signals from detectors 60, 70 are summed in a summation circuit 74, and are then applied to the control input 48.

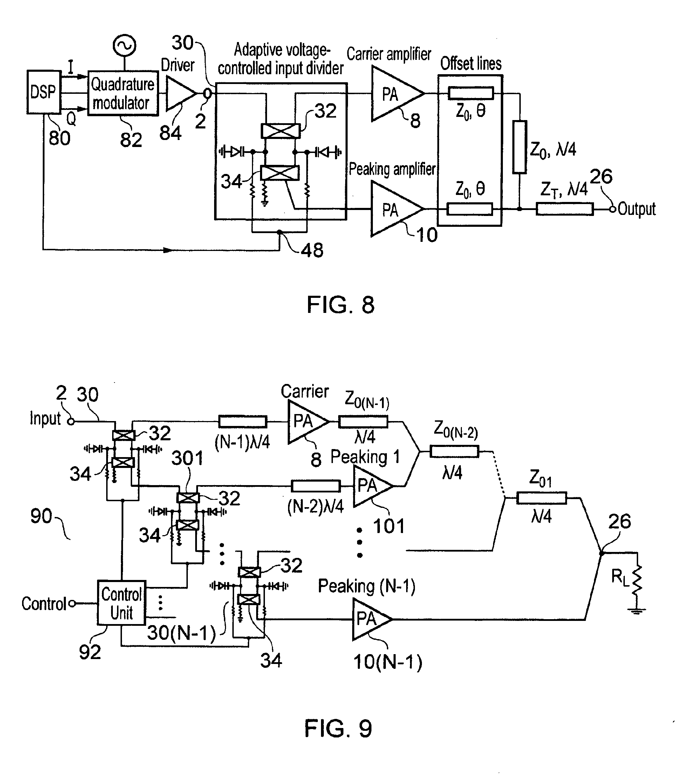

Referring to the third embodiment shown in Figure 8, a DSP digital signal processor 80 generates both input signals to the amplifier, and an envelope signal to the control input 48. The DSP 80 generates I, Q signals. These signals are combined in a Quadrature modulator 82 into a single input signal with two components I, Q which are 90 degrees out of phase. This input signal is connected via a driver amplifier 84 to the power input 2 of the Doherty amplifier.

Referring to the fourth embodiment shown in Figure 9, this is a schematic diagram of a multi stage (N) Doherty amplifier, employing two or more peaking amplifiers (as preferred, only two peaking amplifiers for practicality). The peaking amplifiers 101, ...10i....10(N-1) are arranged to switch on sequentially, as the power of the input signal increases. An array of power dividers 90 provide input signals to the amplifiers. A first path is connected to a carrier power amplifier 8, and (N-1) paths coupled to peaking amplifiers 101 to 10(N-1), having appropriate transmission lines of length λ/4 to (N-1)λ/4 in their input lines. A chain of (N-1) λ/4 lines of impedance Z_{0(N-1)} to Z₀₁ is coupled between the output of Carrier amplifier 8 and the output 26 of the Doherty amplifier, and the outputs of the peaking amplifiers are coupled to nodes between such impedances. It will be noted that this architecture is based on the classic two stage Doherty amplifier, which is exhibited by peaking amplifier 101, connected in parallel with Carrier amplifier 8 and its output inverting impedance Z_{0(N-1)}. As the peaking amplifiers are turned on sequentially, the classic Doherty configuration is again exhibited with the next peaking amplifier due to switch on. In order to maintain phase balance, transmission lines are connected between the divider array and the peaking amplifiers, the lines having a length increasing from (N-1) λ/4 to λ/4.

The divider array comprises a first divider 30, as shown in Figure 3, coupled to carrier amplifier 8. The divider 30 is also coupled to peaking amplifier 101, but via a second divider 301 (similar to divider 30), the first directional coupler 32 of the divider 301 being connected in the input line to amplifier 101. The second directional coupler 34 of divider 301 is coupled to a third divider 302, with the coupler 32 of divider 302 being connected in the input line of peaking amplifier 102, and the second coupler 34 being coupled to the input of peaking amplifier 103, but via the first coupler 32 of a fourth divider 303, etc., etc. The final power divider 30(N-1) in the array has its second coupler 34 connected to the input line of peaking amplifier 10(N-1). A control unit 92 distributes appropriate envelope control signals to the individual power dividers.

The description and drawings merely illustrate the principles of the invention. It will thus be appreciated that those skilled in the art will be able to devise various arrangements that, although not explicitly described or shown herein, embody the principles of the invention and are included within its scope as defined by the appended claims. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. An RF power amplifier including a carrier amplifier, and at least one peaking amplifier,
a power dividing means coupled between an input of the power amplifier and inputs of said carrier amplifier and said one peaking amplifier, the output of said carrier amplifier being coupled through an impedance inversion means to a power amplifier output, and the output of said one peaking amplifier being coupled to said carrier amplifier output, and wherein said one peaking amplifier is configured to switch on with increase in input power,
said power dividing means including a coupler having four ports including an input port, wherein said carrier amplifier is coupled to one of said ports serving as a first outlet port, and said one peaking amplifier is coupled to another of said ports serving as a second outlet port, and including impedance means coupled to said second outlet port, so that, power is partly passed to said one peaking amplifier coupled to the second outlet port, and is partly reflected at said impedance means back into the second outlet port, reappearing at said first outlet port, to which is coupled the carrier amplifier.

2. A power amplifier according to claim 1, wherein said power dividing means comprises first and second couplers, with one or more connecting lines between them, to each of which connecting lines is connected a respective impedance means, so as to partly pass and partly reflect the power that may flow between the two couplers

3. A power amplifier according to claim 1 or 2, said coupler having input, transmitted and coupled ports, wherein a 90° phase shift exists between signals appearing at transmitted and coupled ports, for a signal applied to the input port, and preferably being a directional coupler, or a Lange coupler, or a branch line coupler.

## Patentansprüche

1. RF-Leistungsverstärker, umfassend einen Trägerfrequenzverstärker und zumindest einen Spitzenverstärker,
ein Leistungsteilungsmittel, welches zwischen einem Eingang des Leistungsverstärkers und Eingängen des besagten Trägerfrequenzverstärkers und des besagten einen Spitzenverstärkers gekoppelt ist, wobei der Ausgang des besagten Trägerfrequenzverstärkers über ein Impedanzinversionsmittel an einen Leistungsverstärkerausgang gekoppelt ist und der Ausgang des besagten einen Spitzenverstärkers an den besagten Trägerfrequenzausgang gekoppelt ist, und wobei der besagte Spitzenverstärker für das Einschalten mit ansteigender Eingangsleistung konfiguriert ist,
wobei das besagte Leistungsteilungsmittel einen Koppler mit vier Ports einschließlich eines Eingangsports umfasst, wobei der besagte Trägerfrequenzverstärker an einen der besagten Ports, welcher als ein erster Ausgangsport dient, gekoppelt ist, und wobei der besagte eine Spitzenverstärker an einen anderen der besagten Ports, welcher als ein zweiter Ausgangsport dient, gekoppelt ist, und ein Impedanzmittel umfasst, welches an den besagten zweiten Ausgangsport gekoppelt sind, so dass die Leistung teilweise an den besagten einen an den zweiten Ausgangsport gekoppelten Spitzenverstärker weitergeleitet und teilweise an dem besagten Impedanzmittel in den zweiten Ausgangsport zurückreflektiert wird und erneut an dem besagten ersten Ausgangsport, an welchen der Trägerfrequenzverstärker gekoppelt ist, erscheint.

2. Leistungsverstärker nach Anspruch 1, wobei das besagte Leistungsteilungsmittel einen ersten und einen zweiten Koppler mit einer oder mehreren Verbindungsleitungen zwischen ihnen umfasst, wobei an eine jede dieser Verbindungsleitungen ein jeweiliges Impedanzmittel angeschlossen ist, um die gegebenenfalls zwischen den beiden Kopplern fließende Leistung teilweise weiterzuleiten oder teilweise zu reflektieren.

3. Leistungsverstärker nach Anspruch 1 oder 2, wobei der besagte Koppler Eingangs-, übertragene und gekoppelte Ports aufweist, wobei zwischen an den übertragenen und gekoppelten Ports erscheinenden Signalen für ein auf den Eingangsport angewendetes Signal eine Phasenverschiebung um 90° besteht, und wobei der besagte Koppler vorzugsweise ein Richtkoppler, oder ein Lange-Koppler, oder ein Abzweigleitungskoppler ist.

## Revendications

1. Amplificateur de puissance RF comprenant un amplificateur de porteuse, et au moins un amplificateur de crête,
des moyens de division de puissance couplés entre une entrée de l'amplificateur de puissance et des entrées dudit amplificateur de porteuse et dudit amplificateur de crête, la sortie dudit amplificateur de porteuse étant couplée par l'intermédiaire de moyens d'inversion d'impédance à une sortie de l'amplificateur de puissance, et la sortie dudit amplificateur de crête étant couplée à ladite sortie de l'amplificateur de porteuse, et dans lequel ledit amplificateur de crête est configuré pour s'activer avec l'augmentation de la puissance d'entrée,
lesdits moyens de division de puissance comprenant un coupleur ayant quatre ports comprenant un port d'entrée, dans lequel ledit amplificateur de porteuse est couplé à un desdits ports servant de premier port de sortie, et ledit amplificateur de crête est couplé à un autre desdits ports servant de deuxième port de sortie, et comprenant des moyens d'impédance couplés audit deuxième port de sortie, de sorte que la puissance soit partiellement transmise audit amplificateur de crête couplé au deuxième port de sortie, et soit partiellement renvoyée au niveau desdits moyens d'impédance vers le deuxième port de sortie, réapparaissant au niveau dudit premier port de sortie, auquel l'amplificateur de porteuse est couplé.

2. Amplificateur de puissance selon la revendication 1, dans lequel lesdits moyens de division de puissance comprennent des premier et deuxième coupleurs, avec une ou plusieurs lignes de connexion entre eux, un moyen d'impédance respectif étant connecté à chacune de ces lignes de connexion, de sorte à transmettre partiellement et à renvoyer partiellement la puissance qui peut circuler entre les deux coupleurs.

3. Amplificateur de puissance selon la revendication 1 ou 2, ledit coupleur ayant des ports d'entrée, transmis et couplés, dans lequel un déphasage de 90° existe entre des signaux apparaissant à des ports transmis et couplés, pour un signal appliqué au port d'entrée, et étant de préférence un coupleur directionnel, ou un coupleur Lange, ou un coupleur à interaction localisée.
